# EUROPEAN PATENT APPLICATION

(11) **EP 4 700 581 A1**
(43) Date of publication of application: **25.02.2026**
(21) Application number: 25172412.6
(22) Date of filing: 24.04.2025
(51) Int. Cl.: G06F 11/07, G06F 11/10, G11C 29/02, G11C 29/52

(54) **STORAGE DEVICE AND OPERATING METHOD OF STORAGE CONTROLLER**

(30) Priority: 22.08.2024 KR 20240112898
(71) Applicant: Samsung Electronics Co., Ltd., Suwon-si, Gyeonggi-do 16677 (KR)
(72) Inventor: SHIN, Seo-Hyun, 16677 Suwon-si (KR); LEE, Kyung Duk, 16677 Suwon-si (KR)
(74) Representative: Marks & Clerk LLP

(57) **Abstract**

A storage device comprises a non-volatile memory (NVM) device configured to store data, and a storage controller configured to control the NVM device, in which the storage controller is further configured to send an access command to the NVM device to access data stored in the NVM device, receive first access data corresponding to the access command from the NVM device, perform error correction on the first access data, determine that the first access data is an uncorrectable error correction code (UECC), in response to the first access data being determined as being the UECC, determine that the NVM device is in a busy state, and send a runtime ZQ calibration command to the NVM device in response to the NVM device being determined as being in the busy state.

## Description

### BACKGROUND

As electronic devices are becoming faster and more energy-efficient, high-capacity storage devices used in such devices are desired to operate at high speeds. In certain examples, during a data write operation, a storage device generates an error correction code (ECC) using an ECC circuit, and during a data read operation, the storage device references the ECC to correct any data error. However, in cases where the data read cannot be corrected by the ECC circuit, if read data is determined to be uncorrectable data (UECC - Uncorrectable Error Correction Code), the storage device can execute a defense code to correct the error. An UECC can originate from, for example, degradation of memory cells, but can also arise from the interfacing environment between a storage controller and a non-volatile memory (NVM) because the interfacing environment between the storage controller and the NVM can be affected by process-voltage-temperature (PVT) variations. Executing a defense code to correct a UECC caused by the interfacing environment between the storage controller and the NVM can slow down the storage device's operation speed, as the time required to execute the defense code is not negligible.

### SUMMARY

In general, in some aspect, the present disclosure is directed to a storage device and an operational method of a storage controller that enable enhanced product reliability and highspeed operations.

According to some implementations, the present disclosure is directed to a storage device that comprises a non-volatile memory (NVM) device configured to store data, and a storage controller configured to control the NVM device, wherein the storage controller is further configured to send an access command to the NVM device to access data stored in the NVM device, receive first access data corresponding to the access command from the NVM device, perform error correction on the first access data, determine whether the first access data is an uncorrectable error correction code (UECC), in response to the first access data being determined as being the UECC, determine whether the NVM device is in a busy state, and send a runtime ZQ calibration command to the NVM device in response to the NVM device being determined as being in the busy state.

According to some implementations, the present disclosure is directed to a storage device that comprises a non-volatile memory (NVM) device configured to store data, and a storage controller configured to control the NVM device, wherein the storage controller is further configured to send an access command to the NVM device to access data stored in the NVM device, receive first access data corresponding to the access command from the NVM device, perform error correction on the first access data, determine whether the first access data is an uncorrectable error correction code (UECC), in response to the first access data being determined as being the UECC, determine whether the UECC originates from channel characteristics between the storage controller and the NVM device, in response to the UECC being determined as originating from the channel characteristics, send a runtime ZQ calibration command to the NVM device, and in response to the UECC being determined as not originating from the channel characteristics, execute a defense code for searching for a read level to read data corresponding to the access command.

According to some implementations, the present disclosure is directed to an operating method of a storage controller that comprises sending an access command to a non-volatile memory (NVM) device to access data stored in the NVM device, receiving first access data corresponding to the access command from the NVM device, performing error correction on the first access data, in response to the first access data being determined as being an uncorrectable error correction code (UECC), determining whether the NVM device is in a busy state, and in response to the NVM device being determined as being in the busy state, sending a runtime ZQ calibration command to the NVM device.

At least some of the above and other features of the invention are set out in the claims.

### BRIEF DESCRIPTION OF THE DRAWINGS

Example implementations will be more clearly understood from the following detailed description, taken in conjunction with the accompanying drawings.
FIG. 1 is a block diagram illustrating an example of an electronic system according to some implementations.
FIG. 2 is a diagram illustrating an example of an electronic system according to some implementations.
FIG. 3 is a block diagram illustrating an example of a storage device according to some implementations.
FIG. 4 is a diagram illustrating an example of a semiconductor package according to some implementations.
FIG. 5 is a diagram illustrating an example of a transmission driver for a non-volatile memory (NVM) device according to some implementations.
FIG. 6 is a flowchart illustrating an example of an operation of performing runtime ZQ calibration according to some implementations.
FIG. 7 is a diagram illustrating an example of a storage device according to some some implementations.
FIG. 8 is a timing diagram illustrating an example of an operation of performing runtime ZQ calibration during a data read operation of an NVM device in FIG. 7 according to some implementations.
FIG. 9 is a diagram illustrating an example of a storage device according to some implementations.
FIG. 10 is a timing diagram illustrating an example of an operation of performing runtime ZQ calibration during a data read operation of an NVM device in FIG. 9 according to some implementations.
FIG. 11 is a flowchart illustrating an example of an operation of performing runtime ZQ calibration according to some implementations.
FIG. 12 is a flowchart illustrating an example of an operation of performing runtime ZQ calibration according to some implementations.
FIGS. 13, 14, 15A, and 15B are diagrams for explaining the operation of FIG. 12 according to some implementations.
FIG. 16 is a flowchart illustrating an example of an operation of performing runtime ZQ calibration according to some implementations.
FIG. 17 is a flowchart illustrating an example of an error correction operation through the execution of a defense code according to some implementations.
FIG. 18 is a flowchart illustrating an example of an operation of executing a less read estimation (LRE) defense code as performed in the error correction operation of FIG. 17 according to some implementations.

### DETAILED DESCRIPTION

Hereinafter, example implementations will be described with reference to the accompanying drawings.

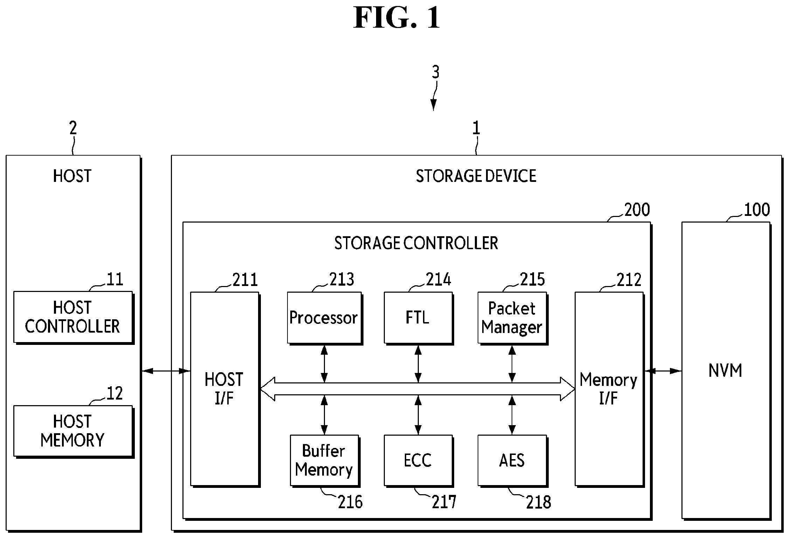

FIG. 1 is a block diagram illustrating an example of an electronic system according to some implementations. In FIG. 1, an electronic system 3 may include a host device 2 and a storage device 1. The storage device 1 may include a storage controller 200 and a non-volatile memory (NVM) device 100. The host device 2 may include a host controller 11 and a host memory 12. The host memory 12 may function as a buffer memory to temporarily store data to be transmitted to the storage device 1 or data transmitted from the storage device 1.

The storage device 1 may include storage media for storing data at the request of the host device 2. For example, the storage device 1 may include at least one of a solid-state drive (SSD), an embedded memory, or a removable external memory. If the storage device 1 is an SSD, the storage device 1 may be, for example, a device that follows the NVM express (NVMe) standard.

If the storage device 1 is an embedded memory or external memory, the storage device 1 may be a device that follows the Universal Flash Storage (UFS) or embedded Multi-Media Card (eMMC) standard. The host device 2 and the storage device 1 may generate and transmit packets according to the adopted standard protocol.

When the NVM device 100 of the storage device 1 includes a flash memory, the flash memory may include a two-dimensional (2D) NAND memory array or a three-dimensional (3D) (or vertical) NAND (VNAND) memory array. In some implementations, the storage device 1 may include various other types of non-volatile memories. For example, the storage device 1 may include a magnetic random-access memory (MRAM), a spin-transfer torque MRAM (STT-MRAM), a conductive bridging random-access memory (CBRAM), a ferroelectric random-access memory (FeRAM), a phase-change random-access memory (PRAM), a resistive random-access memory (ReRAM), and other types of memories.

In some implementations, the host controller 11 and the host memory 12 may be implemented as separate semiconductor chips. In some implementations, the host controller 11 and the host memory 12 may be integrated on the same semiconductor chip. For example, the host controller 11 may be one of multiple modules provided in an application processor (AP), and the AP may be implemented as a system-on-chip (SoC). In addition, the host memory 12 may be an embedded memory provided in the AP or an NVM or memory module disposed outside the AP.

The host controller 11 may manage the operation of storing data (e.g., write data) from a buffer area to the NVM device 100 or storing data (e.g., read data) from the NVM device 100 into the buffer area.

The storage controller 200 may include a host interface 211, a memory interface 212, and a processor 213. Additionally, the storage controller 200 may further include a flash translation layer (FTL) 214, a packet manager 215, a buffer memory 216, an error correction code (ECC) engine 217, and an advanced encryption standard (AES) engine 218.

The storage controller 200 may further include a working memory where the flash translation layer 214 is loaded, and by executing the flash translation layer 214, the processor 213 may control write and read operations of the NVM device 100.

The host interface 211 may transmit packets to and receive packets from the host device 2. Packets transmitted from the host device 2 to the host interface 211 may include commands or data to be written to the NVM device 100, and packets transmitted from the host interface 211 to the host device 2 may include responses to commands or data read from the NVM device 100.

The memory interface 212 may transmit data to be written to the NVM device 100 or receive data read from the NVM device 100. The memory interface 212 may be implemented to comply with standard protocols such as Toggle or Open NAND Flash Interface (ONFI).

The flash translation layer 214 may perform various functions such as address mapping, wear-leveling, and garbage collection. Address mapping operation is the process of converting a logical address received from the host 2 into a physical address for use in actually storing data in the NVM device 100. Wear-leveling is a technique to prevent excessive degradation of particular blocks by ensuring that the blocks in the NVM device 100 are used uniformly. This may be implemented through, for example, firmware technology that balances the erase counts of physical blocks. Garbage collection is a technique for securing available capacity in the NVM device 100 by copying valid data from blocks to new blocks and then erasing the existing blocks.

The packet manager 215 may generate packets according to the protocol of the interface agreed upon with the host device 2 or parse various information from the packets received from the host device 2.

The buffer memory 216 may temporarily store data to be written to the NVM device 100 or data read from the NVM device 100. The buffer memory 216 may be provided within the storage controller 200. In some implementations, the buffer memory 216 may be disposed outside the storage controller 200.

The ECC engine 217 may perform error detection and correction for read data from the NVM device 100. For example, the ECC engine 217 may generate parity bits for write data to be written to the NVM device 100, and the generated parity bits may be stored in the NVM device 100 along with the write data. When reading data from the NVM device 100, the ECC engine 217 may use the parity bits read from the NVM device 100 along with the read data to correct any errors in the read data and output the corrected read data. The ECC engine 217 may use, for example, low-density parity check (LDPC) code for error correction, but the present disclosure is not limited thereto. In some implementations, the ECC engine 217 may perform error correction using codes, such as a Bose-Chaudhuri-Hocquenghem (BCH) code, turbo code, Reed-Solomon code, convolutional code, recursive systematic code (RSC), trellis-coded modulation (TCM), and block-coded modulation (BCM), to perform error correction.

The ECC engine 217 may determine whether error correction decoding has been successful and output an indication signal based on the result of the determination. However, there is a limit in the number of error bits that the ECC engine 217 can correct. If the data received by the ECC engine 217 contains more error bits than it can correct, an uncorrectable error correction code (UECC) error may occur.

The AES engine 218 may perform at least one of an encryption operation or a decryption operation on the data input to the storage controller 200 using a symmetric-key algorithm.

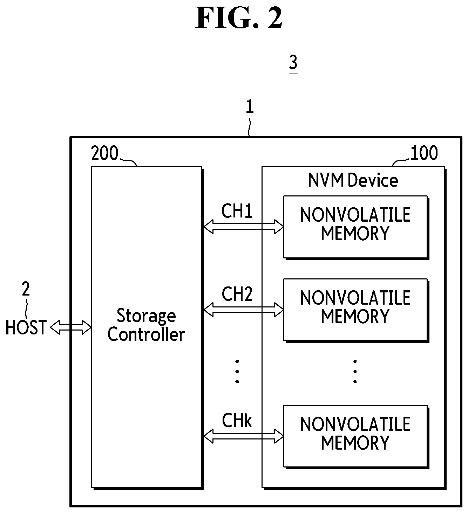

FIG. 2 is a diagram illustrating an example of an electronic system according to some implementations. In FIG. 2, the electronic system 3 includes the host device 2 and the storage device 1. The electronic system 3 may be implemented as a personal computer (PC), a data server, a laptop computer, or a portable device. The electronic system 3 may be implemented as a portable device, such as a mobile phone, a smartphone, a tablet PC, a personal digital assistant (PDA), an enterprise digital assistant (EDA), a digital still camera, a digital video camera, a portable multimedia player (PMP), a personal navigation device (PND) or a portable navigation device, a handheld game console, or an e-book reader. Additionally, the electronic system 3 may also be implemented as a System-On-Chip (SoC).

The host device 2 may include a host controller that controls the overall operation of the electronic system 3. The host controller may control the operations of both the host device 2 and the storage device 1. The host controller may generate commands to control the operation of the electronic system 3 and transmit the generated commands to the electronic system 3.

The host device 2 may request data processing operations such as a data read operation, a data write (or program) operation, and a data erase operation to the storage device 1. For example, the host device 2 may be a central processing unit (CPU), a graphics processing unit (GPU), a microprocessor, or an application processor (AP).

The storage device 1 includes a storage controller 200 and an NVM device 100. The storage device 1 may be implemented as various types of storage devices, such as an SSD, an eMMC, a UFS, or a Compact Flash (CF) card, a Secure Digital (SD) card, a micro SD (micro-SD) card, a mini SD (mini-SD) card, an extreme Digital (xD) card, or a memory Stick.

The storage controller 200 may be coupled to the host device 2 and the storage device 1. In response to a request from the host device 2, the storage controller 200 may be configured to access the NVM device 100. For example, the storage controller 200 may be implemented to control the overall operation of the storage device 1. The storage controller 200 may perform various management operations such as cache/buffer management, firmware management, garbage collection management, wear leveling management, data deduplication management, read refresh/reclaim management, bad block management, multi-stream management, host data/NVM mapping management, quality-of-service (QoS) management, system resource allocation management, NVM queue management, read level management, erase/program management, hot/cold data management, power loss protection management, dynamic thermal management, and initialization management.

The storage controller 200 may be configured to provide an interface between the storage device 1 and the host device 2. Additionally, the storage controller 200 may be configured to execute firmware to control the storage device 1, either at the request of the host device 2 or autonomously. For example, the storage controller 200 may further include well-known components, such as a memory, a controller control unit, a host interface, and a memory interface.

The host interface of the storage controller 200 may include a protocol for data exchange between the host device 2 and the storage controller 200. For example, the storage controller 200 may be configured to communicate with the host device 2 through at least one of various interface protocols, such as the Universal Serial Bus (USB) protocol, the multimedia card (MMC) protocol, the Peripheral Component Interconnection (PCI) protocol, the PCI-express (PCI-E) protocol, the Advanced Technology Attachment (ATA) protocol, the serial-ATA protocol, the parallel-ATA protocol, the small computer system interface (SCSI) protocol, the enhanced small disk interface (ESDI) protocol, and the Integrated Drive Electronics (IDE) protocol.

The storage device 1 may include, for example, a plurality of NVMs, such as NVM11 through NVMmn. The NVMs NVM11 through NVMmn may communicate with the storage controller 200 through, for example first through k-th channels CH1 through CHk.

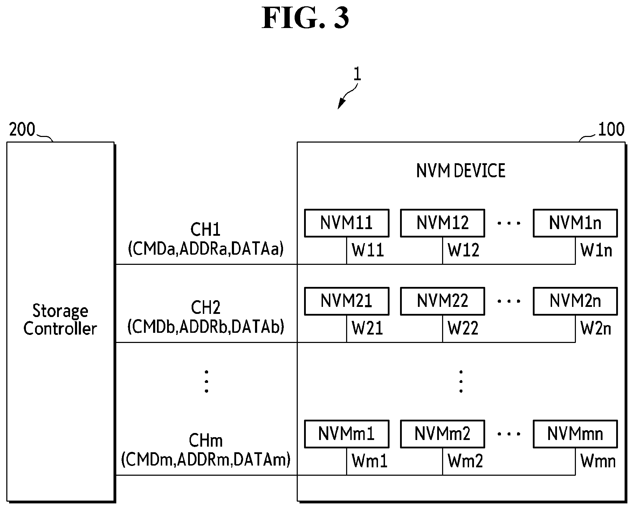

FIG. 3 is a block diagram illustrating an example of a storage device according to some implementations. In FIG. 3, a storage device 1 may include an NVM device 100 and a storage controller 200. The storage device 1 may support a plurality of first through m-th channels CH1 through CHm, and the NVM device 100 and the storage controller 200 may be connected through the first through m-th channels CH1 through CHm. For example, the storage device 1 may be implemented as a storage device such as an SSD.

The NVM device 100 may include a plurality of NVMs NVM11 through NVMmn. Each of the NVMs NVM11 through NVMmn may be connected to one of the first through m-th channels CH1 through CHm via a corresponding way. For example, the NVMs NVM11 through NVM1n may be connected to the first channel CH1 via ways W11 through W1n, and the NVMs NVM21 through NVM2n may be connected to the second channel CH2 via ways W21 through W2n. In some implementations, each of the NVMs NVM11 through NVMmn may be implemented as an independent memory unit that can operate according to individual commands from the storage controller 200. For example, each of the NVMs NVM11 through NVMmn may be implemented as a chip or a die, but the present disclosure is not limited thereto.

The storage controller 200 may transmit signals to and receive signals from the NVM device 100 through the first through m-th channels CH1 through CHm. For example, the storage controller 200 may transmit commands CMDa through CMDm, addresses ADDRa through ADDRm, and data DATAa through DATAm to the NVM device 100 through the first through m-th channels CH1 through CHm, or may receive the data DATAa through DATAm from the NVM device 100.

The storage controller 200 may select one of the NVMs NVM11 through NVMmn connected to the first through m-th channels CH1 through CHm, and may exchange signals with the selected NVM. For example, the storage controller 200 may select the NVM NVM11 from among the NVMs NVM11 through NVM1n that are connected to the first channel CH1. The storage controller 200 may transmit the command CMDa, the address ADDRa, and the data DATAa to the selected NVM NVM11, or receive the data DATAa from the selected NVM NVM11, through the first channel CH1.

The storage controller 200 may transmit signals to, and receive signals from, the NVM device 100 in parallel through different channels. For example, the storage controller 200 may transmit the command CMDa to the NVM device 100 through the first channel CH1 while simultaneously transmitting the command CMDb through the second channel CH2. For example, the storage controller 200 may receive the data DATAa from the NVM device 100 through the first channel CH1 while simultaneously receiving the data DATAb from the NVM device 100 through the second channel CH2.

The storage controller 200 may control the overall operation of the NVM device 100. The storage controller 200 may transmit signals to the first through m-th channels CH1 through CHm to control the NVMs NVM11 through NVMmn connected to the first through m-th channels CH1 through CHm. For example, the storage controller 200 may transmit the command CMDa and the address ADDRa to the first channel CH1 to control one of the NVMs NVM11 through NVM1n that is selected.

Each of the NVMs NVM11 through NVMmn may operate under the control of the storage controller 200. For example, the NVMNVM11 may program the data DATAa according to the command CMDa and the address ADDRa provided through the first channel CH1. For example, the NVM NVM21 may read the data DATAb according to the command CMDb and the address ADDRb provided through the second channel CH2 and may transmit the read data DATAb to the storage controller 200.

In FIG. 3, the NVM device 100 communicates with the storage controller 200 through m channels, i.e., the first through m-th channels CH1 through CHm, and the storage device 1 includes n NVMs for each of the first through m-th channels CH1 through CHm. However, the number of channels and the number of NVMs connected to each channel may vary.

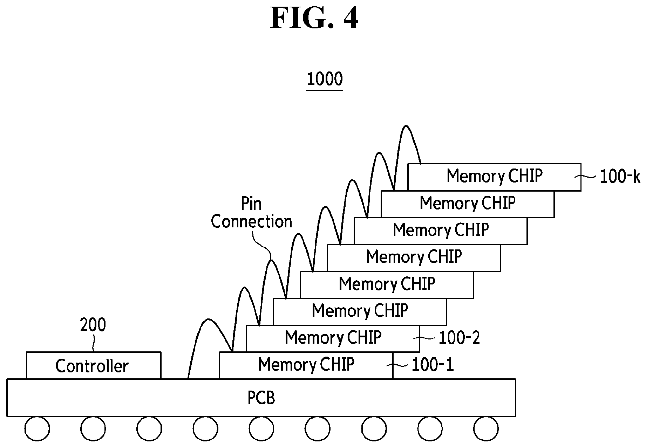

FIG. 4 is a diagram illustrating an example of a semiconductor package according to some implementations. In FIG. 4, a semiconductor package 1000 may include a substrate PCB, a storage controller 200, and semiconductor structures 100-1 through 100-k. The substrate PCB may be a printed circuit board. The substrate PCB may have a layered structure where insulating and wiring layers are alternately stacked.

The storage controller 200 and the semiconductor structures 100-1 through 100-k may be disposed on the upper surface of the substrate PCB. External connection terminals may be disposed on the lower surface of the substrate PCB. The external connection terminals may be spaced apart from one another. For example, the external connection terminals may include solder balls or solder bumps.

The storage controller 200 may be electrically connected to the semiconductor structures 100-1 through 100-k through at least one of the wiring layers in the substrate PCB or pin connection wires.

The semiconductor structures 100-1 through 100-k may be vertically stacked in a first direction (e.g., a vertical direction). The semiconductor structures 100-1 through 100-k may be disposed in an offset stack structure on the substrate PCB. For example, the semiconductor structures 100-1 through 100-k may be tilted and stacked in the first direction, forming a step-like structure. As a result, portions of the upper surfaces of the semiconductor structures 100-1 through 100-k may be exposed.

Each of the semiconductor structures 100-1 through 100-k may include at least one NVM device. The semiconductor structures 100-1 through 100-k may be electrically connected to the substrate PCB and the storage controller 200 through pin connection wires to transmit and receive signals. The pin connection wires may be formed of a metal, and a plurality of pin connection wires may be provided. For example, the pin connection wires may correspond to the first through k-th channels CH1 through CHk in FIG. 3.

The storage controller 200 may transmit independent control signals to each of the semiconductor structures 100-1 through 100-k. However, as the number of semiconductor structures 100-1 through 100-k included in the semiconductor package 1000 increases, the frequency of input/output signals between the storage controller 200 and each of the semiconductor structures 100-1 through 100-k increases, and signal integrity (SI) issues may arise due to the high-capacity semiconductor package 1000. Accordingly, runtime ZQ calibration is important for signals transmitted to and received from each of the semiconductor structures 100-1 through 100-k.

As the operating conditions of a storage device, such as PVT, fluctuate, the impedance of each channel through which data is transmitted also changes.

ZQ calibration adjusts an impedance code according to various operating conditions to ensure the operational reliability of the storage device, even when the impedance of each channel changes. The adjusted impedance code minimizes impedance mismatch between the storage controller 200 and the NVM devices within the semiconductor structures 100-1 through 100-k, thus improving the operational reliability of the storage device.

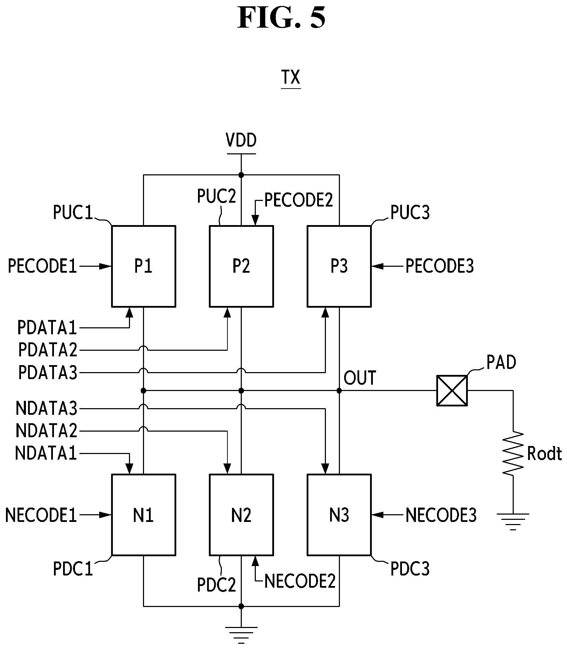

FIG. 5 is a diagram illustrating an example of a transmission driver for an NVM device according to some implementations. In FIG. 5, a transmission driver TX at the transmitting end of an NVM device may include pull-up circuits PUC1, PUC2, and PUC3 and pull-down circuits PDC1, PDC2, and PDC3.

A data signal generator of the NVM device may generate pull-up data signals PDATA1, PDATA2, and PDATA3 according to data to be transmitted by the transmission driver TX. In some implementations, for the data to be transmitted by the transmission driver TX, the data signal generator of the NVM device may generate the pull-up data signals PDATA1, PDATA2, and PDATA3, but the present disclosure is not limited thereto.

The pull-up data signal PDATA1 may determine whether to turn on the pull-up circuit PUC1, the pull-up data signal PDATA2 may determine whether to turn on the pull-up circuit PUC2, and the pull-up data signal PDATA3 may determine whether to turn on the pull-up circuit PUC3.

A pull-up enable code PECODE1, which is an impedance code, may be provided to the pull-up circuit PUC1. The pull-up enable code PECODE1 may determine the number of pull-up units to be enabled within the pull-up circuit PUC1. A pull-up enable code PECODE2, which is an impedance code, may be provided to the pull-up circuit PUC2. The pull-up enable code PECODE2 may determine the number of pull-up units to be enabled within the pull-up circuit PUC2. A pull-up enable code PECODE3, which is an impedance code, may be provided to the pull-up circuit PUC3. The pull-up enable code PECODE3 may determine the number of pull-up units to be enabled within the pull-up circuit PUC3.

Here, the pull-up data signals PDATA1, PDATA2, and PDATA3 are independent signals, and the pull-up enable codes PECODE1, PECODE2, and PECODE3 are independent codes. Accordingly, the pull-up circuits PUC1, PUC2, and PUC3 may be independently turned on or off, and the numbers of pull-up units enabled in the pull-up circuits PUC1, PUC2, and PUC3 may be independent of one another.

The pull-up circuit PUC1 may include a plurality of pull-up units that are enabled based on the pull-up enable code PECODE1. The pull-up circuits PUC2 and PUC3 may have the same configuration as the pull-up circuit PUC1.

The number of pull-up units included in the pull-up circuit PUC1 may be related to the number of bits in the pull-up enable code PECODE1. For example, if the pull-up enable code PECODE1 has 5 bits, the pull-up circuit PUC1 may include 31 pull-up units.

As described earlier, since the pull-up enable codes PECODE1, PECODE2, and PECODE3 are independent codes, the numbers of pull-up units enabled in the pull-up circuits PUC1, PUC2, and PUC3 may be independent of one another.

For example, when the values of the pull-up enable codes PECODE1, PECODE2, and PECODE3 differ from one another, the number of pull-up units enabled in the pull-up circuit PUC1, the number of pull-up units enabled in the pull-up circuit PUC2, and the number of pull-up units enabled in the pull-up circuit PUC3 may differ.

The data signal generator of the NVM device may generate pull-down data signals NDATA1, NDATA2, and NDATA3 according to the data to be transmitted by the transmission driver TX. In some implementations, for the data to be transmitted by the transmission driver TX, the data signal generator of the NVM device may generate the pull-down data signals NDATA1, NDATA2, and NDATA3, but the present disclosure is not limited thereto.

The pull-down data signal NDATA1 may determine whether to turn on the pull-down circuit PDC1, the pull-down data signal NDATA2 may determine whether to turn on the pull-down circuit PDC2, and the pull-down data signal NDATA3 may determine whether to turn on the pull-down circuit PDC3.

A pull-down enable code NECODE1, which is an impedance code, may be provided to the pull-down circuit PDC1. The pull-down enable code NECODE1 may determine the number of pull-down units to be enabled within the pull-down circuit PDC1. The pull-down enable code NECODE2, which is an impedance code, may be provided to the pull-down circuit PDC2. The pull-down enable code NECODE2 may determine the number of pull-down units to be enabled within the pull-down circuit PDC2. A pull-down enable code NECODE3, which is an impedance code, may be provided to the pull-down circuit PDC3. The pull-down enable code NECODE3 may determine the number of pull-down units to be enabled within the pull-down circuit PDC3.

Here, the pull-down data signals NDATA1, NDATA2, and NDATA3 are independent signals, and the pull-down enable codes NECODE1, NECODE2, and NECODE3 are independent codes. Accordingly, the pull-down circuits PDC1, PDC2, and PDC3 may be independently turned on or off, and the numbers of pull-down units enabled in the pull-down circuits PDC1, PDC2, and PDC3 may be independent of one another.

The pull-down circuit PDC1 may include a plurality of pull-down units that are enabled based on the pull-down enable code NECODE1. The pull-down circuits PDC2 and PDC3 may have the same configuration as the pull-down circuit PDC1.

The number of pull-down units included in the pull-down circuit PDC1 may be related to the number of bits in the pull-down enable code NECODE1. For example, if the pull-down enable code NECODE1 has 5 bits, the pull-down circuit PDC1 may include 31 pull-down units.

In some implementations, the numbers of pull-up units included in the pull-up circuits PUC1, PUC2, and PUC3 and the numbers of pull-down units included in the pull-down circuits PDC1, PDC2, and PDC3 may be the same.

As described earlier, since the pull-down enable codes NECODE1, NECODE2, and NECODE3 are independent codes, the numbers of pull-down units enabled in the pull-down circuits PDC1, PDC2, and PDC3 may be independent of one another.

For example, when the pull-down enable codes NECODE1, NECODE2, and NECODE3 have different values, the numbers of pull-down units enabled in the pull-down circuit PDC1, PDC2, and PDC3 may differ.

Based on the pull-up enable codes PECODE1, PECODE2, and PECODE3 and the pull-down enable codes NECODE1, NECODE2, and NECODE3, which are all impedance codes, an on-resistance Ron of the pull-up circuits PUC1, PUC2, and PUC3 and the pull-down circuits PDC1, PDC2, and PDC3 may be adjusted. As a result, a voltage divided from a power supply voltage VDD may be applied to an output node OUT, and by outputting this voltage to an output pad PAD, an output signal may be output from the transmission driver TX.

ZQ calibration is the process of determining the pull-up enable codes PECODE1, PECODE2, and PECODE3, and the pull-down enable codes NECODE1, NECODE2, and NECODE3 to ensure that the on-resistance Ron of the pull-up circuits PUC1, PUC2, and PUC3, and the pull-down circuits PDC1, PDC2, and PDC3 impedance-match an on-die termination (ODT) resistance Rodt.

In FIG. 5, a transmission driver Tx is shown, but the present disclosure is not limited thereto.

In FIG. 4, the semiconductor structures 100-1 through 100-k included in the semiconductor package 1000 share the same transmission circuit. For example, ZQ calibration may be performed when the semiconductor package 1000 is first powered on. However, since the transmission channel environment with the storage controller 200 varies depending on the arrangement of the semiconductor structures 100-1 through 100-k, and the transmission channel environment with the storage controller 200 continues to change during the input and output of data, there is a need for a technology that can perform runtime ZQ calibration to optimize the data transmission and reception environment.

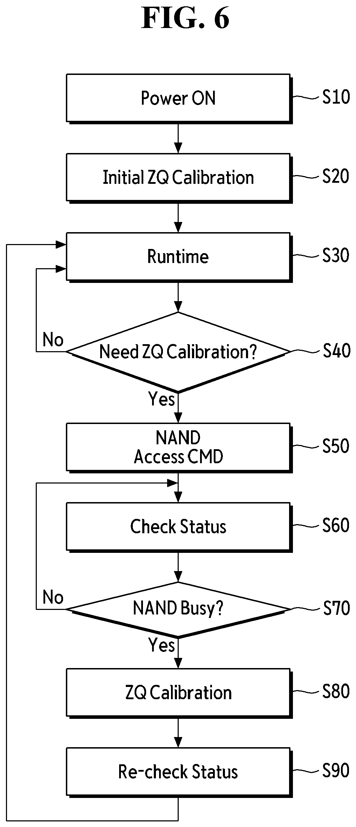

FIG. 6 is a flowchart illustrating an example of an operation of performing runtime ZQ calibration according to some implementations. In FIGS. 2 and 6, when the storage device 1 is powered on (S10), the storage device 1 performs an initial ZQ calibration (S20). At this time, the storage controller 200 provides a ZQ calibration command to the NVM device 100, and ZQ calibration is performed on the transmission ends of both the storage controller 200 and the NVM device 100, determining an impedance code.

Thereafter, the storage device 1 performs a normal operation during runtime based on the impedance code determined by the initial ZQ calibration (S30).

Thereafter, the storage device 1 monitors the interface between the storage controller 200 and the NVM device 100 to determine whether ZQ calibration needs to be performed again during runtime (S40).

If ZQ calibration is not needed (S40 - No), the normal operation is continued during runtime (S30).

If ZQ calibration is needed again (S40 - Yes), the storage controller 200 sends a data access command (e.g., a read command, a program command, or an erase command) to the NVM device 100 (S50) and checks the status of the NVM device 100 (S60).

If the status of the NVM device 100 is not busy (S70 - No), the check of the status of the NVM device 100 is continued (S60).

If the status of the NVM device 100 is confirmed to be busy (S70 - Yes), runtime ZQ calibration is performed (S80).

After performing the runtime ZQ calibration, the storage interface (SI) status of the channel between the NVM device 100 and the storage controller 200 is re-checked based on the newly determined impedance code (S90).

If the SI status of the first through k-th channels CH1 through CHk between the NVM device 100 and the storage controller 200 is good, the normal operation is continued during runtime (S30).

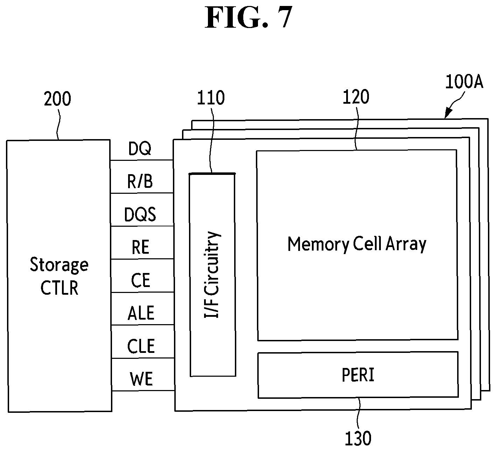

FIG. 7 is a diagram illustrating an example of a storage device according to some implementations. A memory interface ("212" in FIG. 1) of a storage controller 200 may transmit and receive signals through a plurality of pins with an input/output interface 110 of at least one non-volatile memory device 100A. For example, the plurality of pins may transmit and receive signals such as DQ, R/B, DQS, RE, CE, ALE, CLE, and WE. That is, DQ, R/B, DQS, RE, CE, ALE, CLE, and WE pins may transmit and receive DQ, R/B, DQS, RE, CE, ALE, CLE, and WE signals, respectively.

The received signals may be transmitted to a memory cell array 120 through a peripheral circuit 130, and data stored in the memory cell array 120 or a status signal of the NVM device 100A may be generated through the peripheral circuit 130 and transmitted to the storage controller 200 via the input/output interface 110.

Each of the memory cell arrays 120 includes a plurality of memory blocks, and each of the plurality of memory blocks may have a planar or three-dimensional structure. Each of the memory cell arrays 120 may include at least one of single-level cell (SLC) blocks containing single-level cells, multi-level cell (MLC) blocks containing multi-level cells, triple-level cell (TLC) blocks containing triple-level cells, or quad-level cell (QLC) blocks containing quad-level cells. For example, some of the plurality of memory blocks may be SLC blocks, other memory blocks may be MLC blocks, TLC blocks, or QLC blocks.

Memory cells included in each of the memory cell arrays 120 may each store 2 bits or more of data. For example, the memory cells may be MLCs that store 2-bit data. In another example, the memory cells may be TLCs that store 3-bit data or QLCs that store 4-bit data. However, the present disclosure is not limited to these examples. In some implementations, some of the memory cells may be SLCs that store 1-bit data, and other memory cells may be MLCs.

The DQ signal is a data signal, and a command CMD, an address ADDR, and data DATA may be transmitted through the DQ signal. The DQ signal may be transmitted through a plurality of data signal lines. The R/B signal is a signal indicating the operational status between the storage controller 200 and the NVM device 100A. If the NVM device 100A is operating, the storage controller 200 sends a signal indicating a busy state to the NVM device 100A, and if the NVM device 100A is idle, the storage controller 200 sends a signal indicating a ready state.

The DQS signal is a data strobe signal, and the RE signal is a read enable signal. When reading data from the NVM device 100A, the RE signal is input as a data output control signal. The RE signal may be used to generate the DQS signal.

The CE signal is a chip enable signal that allows the storage controller 200 to selectively activate and access at least one NVM device 100A.

The CLE signal is a command latch enable signal, and the ALE signal is an address latch enable signal. When the command CMD is included in the DQ signal, the CLE signal is enabled, and when the address ADDR is included in the DQ signal, the ALE signal is enabled. When general data is transmitted via the DQ signal, the CLE signal and the ALE signal are both disabled.

The WE signal is a write enable signal, and the storage controller 200 may transmit the DQ signal containing the command CMD or the address ADDR and a switched WE signal to the NVM device 100A.

For example, the NVM device 100A may latch the command CMD or the address ADDR at an edge of the WE signal according to the CLE signal and the ALE signal and may thereby perform a write (or program) operation, a read operation, or an erase operation. For example, during a read operation, the CE signal is activated, the CLE signal is activated during the transmission of the command CMD, the ALE signal is activated during the transmission of the address ADDR, and the RE signal toggles during the transmission of the data DATA via the data signal lines. The DQS signal may toggle at a frequency corresponding to the input/output speed of the data DATA. Read data may be sequentially transmitted from the NVM device 100A to the storage controller 200 in synchronization with the DQS signal.

Each of the plurality of pins may transmit and receive signals independently. In some implementations, when the storage controller 200 transmits an access command and address for a read, program, or erase operation to the NVM device 100A via the DQ pin, the NVM device 100A transmits an R/B signal indicating a busy state via the R/B pin while performing an operation corresponding to the access command.

For example, when signals are transmitted through the R/B pin, the DQ pin may not be in use. Runtime ZQ calibration may be performed when the R/B pin transmits a busy state signal, but the DQ pin is not in use. Here, the NVM device 100A may support plane independent commands (PICs).

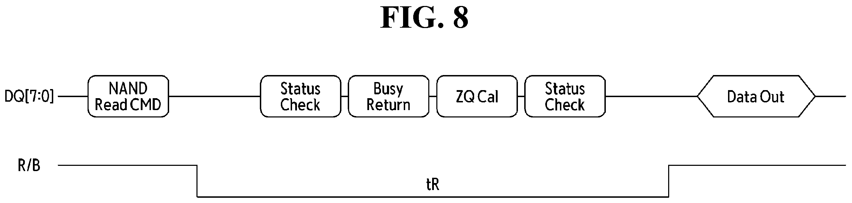

FIG. 8 is a timing diagram illustrating an example of an operation of performing runtime ZQ calibration during a data read operation of an NVM device in FIG. 7 according to some implementations. In FIGS. 7 and 8, when the storage controller 200 sends a read command Read CMD through the DQ pin, the NVM device 100A performs a read operation and sends a logic-low R/B signal through the R/B pin. In FIG. 8, tR refers to a logic-low period corresponding to the busy state from the read operation.

The period when the logic-low R/B signal is sent through the R/B pin corresponds to the period when the NVM device 100A is reading data from the memory cell array 120, and no commands, addresses, or data are transmitted through the DQ pin.

In some implementations, runtime ZQ calibration, which is for reflecting changes in the characteristics of the channel between the storage controller 200 and the NVM device 100A, is performed using the idle period of the DQ pin.

For example, when the logic-low R/B signal is being transmitted through the R/B pin, the storage controller 200 sends a status check command to the NVM device 100A, and the NVM device 100A checks its internal status and replies that it is in the busy state ("Busy Return"). Once the storage controller 200 receives busy status information from the NVM device 100A, the storage controller 200 sends a command that gives instructions to perform runtime ZQ calibration ("ZQ Cal"). Subsequently, the storage controller 200 checks the status of the NVM device 100A ("Status Check") to determine whether the runtime ZQ calibration has been successfully performed (i.e., determine the pass/fail status of the runtime ZQ calibration). After the NVM device 100A completes the reading of data from the memory cell array 120, the R/B pin changes to a logic-high level, indicating a ready state, and the read data is transmitted from the NVM device 100A to the storage controller 200 through the DQ pin ("Data Out").

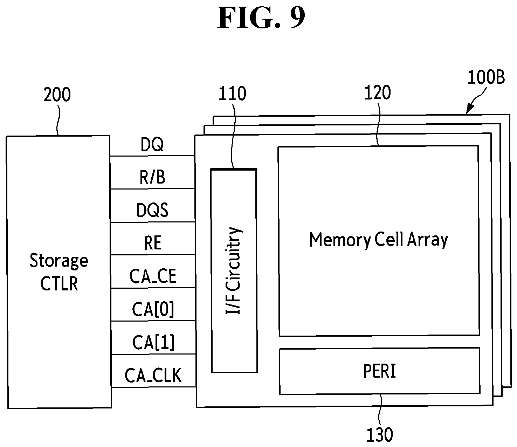

FIG. 9 is a diagram illustrating an example of a storage device according to some implementations. In FIG. 9, unlike in the implementation of FIG. 7, a storage controller 200 and at least one NVM device 100B are connected via a separate command address (SCA) interface. For convenience, content that overlaps with what has been described above with reference to FIG. 7 will be omitted.

In FIG. 9, the SCA interface is an interface that connects a plurality of pins between the storage controller 200 and the NVM device 100B in an SCA mode. In the SCA mode, unlike in a PIC mode described above with reference to FIG. 7, a signal line for transmitting commands and a signal line for transmitting addresses are independent. Since the command signal line and the address signal line are separate in the SCA mode, the storage controller 200 can transmit commands or address signals via a separate signal line even while accessing the NVM device 100B through a DQ signal line. For example, DQ, R/B, DQS, RE, CA_CE, CA[0], CA[1], and CA_CLK pins may transmit DQ, R/B, DQS, RE, CA_CE, CA[0], CA[1], and CA_CLK signals, respectively. The DQ, R/B, DQS, and RE signals are the same as their respective counterparts of FIG. 7, and detailed descriptions thereof will be omitted.

The CA_CE signal is a command/address chip enable signal used to activate a particular NVM chip. The CA[0] signal is a signal for transmitting commands or addresses, the CA[1] signal is also a signal for transmitting commands or addresses, and the CA_CLK signal is a clock signal for command and address signals. For example, CA[1:0] may be referred to as a command/address signal line, and DQ may be referred to as a data signal line.

The CA_CLK signal is an external clock signal provided by the storage controller 200, and the NVM device 100B may generate a plurality of internal clocks that are phase-shifted or divided based on the CA_CLK signal, and may operate based on the internal clocks. The CA[0] signal operates in synchronization with one of the internal clocks, and the CA[1] signal operates in synchronization with another one of the internal clocks.

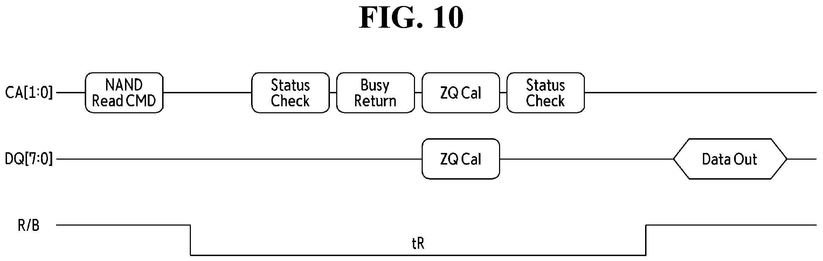

FIG. 10 is a timing diagram illustrating an example of an operation of performing runtime ZQ calibration during a data read operation of an NVM device in FIG. 9 according to some implementations. In FIGS. 9 and 10, when the storage controller 200 sends a read command Read CMD through the CA[1:0] pin, the NVM device 100B performs a read operation and sends a logic-low busy signal tR through the R/B pin.

When the logic-low busy signal is being sent through the R/B pin, the storage controller 200 sends a status check command through the CA[1:0] pin, and the NVM device 100B may reply that it is in a busy state ("Busy Return"). In response to the busy return from the NVM device 100B, the storage controller 200 may send a command to perform runtime ZQ calibration to the NVM device 100B ("ZQ Cal"). In some implementations, the runtime ZQ calibration command may also be sent through the DQ pin ("ZQ Cal") when being transmitted through the CA[1:0] pin.

Thereafter, the storage controller 200 checks the status of the NVM device 100B ("Status Check") to determine whether the runtime ZQ calibration has been successfully performed (i.e., determine the pass/fail status of the runtime ZQ calibration). Once the NVM device 100B completes the reading of data read from the memory cell array 120, the R/B pin changes to a logic-high level indicating a ready state, and the read data is transmitted from the NVM device 100B to the storage controller 200 through the DQ pin ("Data Out").

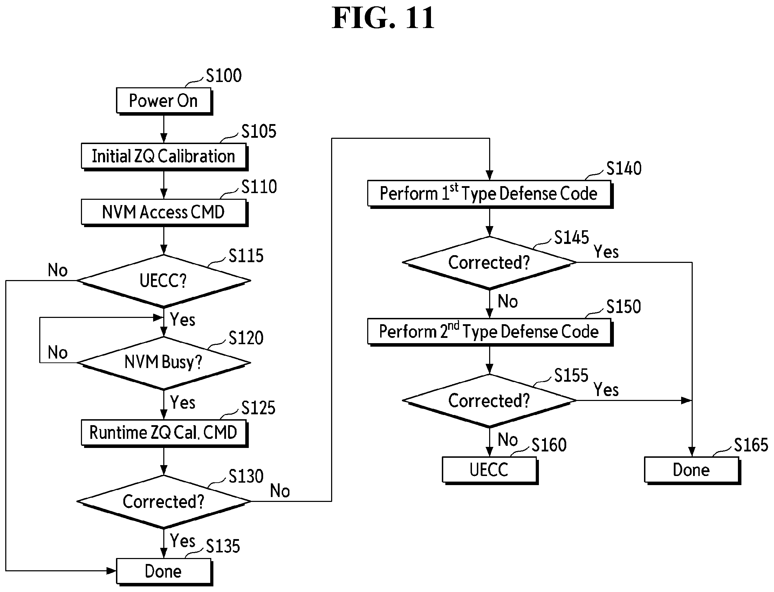

FIG. 11 is a flowchart illustrating an example of an operation of performing runtime ZQ calibration according to some implementations. In FIG. 11, a storage device is powered on (S100).

Thereafter, an initial ZQ calibration is performed (S105). For example, referring to FIG. 7, the storage controller 200 provides a ZQ calibration command to the NVM device 100A, and ZQ calibration is performed on both the transmission end of the storage controller 200 and the transmission end of the NVM device 100A, determining an impedance code. Thereafter, the storage device performs a normal operation during runtime based on the impedance code determined by the initial ZQ calibration.

Thereafter, an access command is sent (S110). For example, referring to FIG. 7, the storage controller 200 may send an access command to the NVM device 100A to access the data stored in the NVM device 100A.

In some implementations, the access command may be, for example, a read command to read the data stored in the NVM device 100A, but the present disclosure is not limited thereto. In some implementations, the access command may include a command for performing garbage collection, a command for performing read reclaim, or a command for performing a read-write operation to access the data stored in the NVM device 100A.

As described earlier, in the storage device of FIG. 7, the access command may be transmitted using the DQ pin, as illustrated in FIG. 8, and in the storage device of FIG. 9, the access command may be transmitted using the CA[1:0] pin, as illustrated in FIG. 10. The operation of performing runtime ZQ calibration will hereinafter be explained using the storage device of FIG. 7 as an example, but the following description may also be applicable to the storage device of FIG. 9.

In FIG. 7, after receiving the access command from the storage controller 200, the NVM device 100A may, for example, transmit access data corresponding to the access command to the storage controller 200 through the DQ pin.

Thereafter, in FIG. 11, error correction is performed on the access data, and a determination is made as to whether the access data is a UECC (S115).

Here, the error correction may be performed by, for example, the ECC engine ("217" in FIG. 1) of the storage controller, as described above.

If the access data has been successfully error-corrected (S115 - No), the operation of performing runtime ZQ calibration according to some embodiments is terminated (S135). In this case, referring to FIG. 1, the storage controller 200 may transmit the error-corrected access data to an external device such as the host device 2, or if necessary, transmit it back to the NVM device 100.

If the error correction for the access data has failed (S115 - Yes), a determination is made as to whether an NVM device is in a busy state (S120).

For example, in FIG. 7, when the access data is determined as being a UECC, the storage controller 200 may determine whether the NVM device 100A is in the busy state to perform runtime ZQ calibration to improve the characteristics of the channel between the storage controller 200 and the NVM device 100A.

In some implementations, the storage controller 200 may determine whether the NVM device 100A is in the busy state by checking if a logic-low busy signal tR is being transmitted through the R/B pin, as already described earlier.

If the NVM device is not in the busy state (S120 - No), the storage controller waits until the NVM device enters the busy state.

If the NVM device is in the busy state (S120 - Yes), the storage controller sends a runtime ZQ calibration command (S125).

For example, in FIG. 7, if the NVM device 100A is not in the busy state, the storage controller 200 may wait until the NVM device 100A enters the busy state.

When the storage controller 200 determines that the NVM device 100A is in the busy state, the storage controller 200 may send a runtime ZQ calibration command to the NVM device 100A, as illustrated in FIG. 8.

Accordingly, runtime ZQ calibration is performed to reflect the channel characteristics between the storage controller 200 and the NVM device 100A, and the existing impedance code may be updated.

Thereafter, the storage controller 200 may re-receive the access data corresponding to the access command using the transmitter of the NVM device 100A with the updated impedance code. The storage controller 200 then performs error correction on the re-received access data to determine whether the re-received access data is error-corrected (S130).

If the re-received access data is error-corrected (S130 - Yes), the operation of performing runtime ZQ calibration according to some embodiments is terminated (S135). Conversely, if the re-received access data is not error-corrected (S130 - No), the storage controller performs a first-type defense code (S140).

For example, in FIG. 1, the storage controller 200 may perform the first-type defense code using a table stored in the buffer memory 216. For example, the processor 213 of the storage controller 200 may execute an algorithm corresponding to the first-type defense code using the table stored in the buffer memory 216, thus allowing the storage controller 200 to execute the first-type defense code.

Generally, a NAND flash memory-based storage device, such as an SSD or UFS, applies various technologies designed to extend product lifespan by mitigating the degradation of NAND flash memories that occurs over time. These technologies are referred to as defense codes. The degradation of NAND flash memories may be caused by process miniaturization and various external environmental factors. As the NAND flash memories degrade, the number of errors in read data increases, making data recovery through ECC more difficult and exacerbating product reliability.

The defense codes are for suppressing the increase of errors caused by NAND flash memory degradation to support ECC in data recovery.

Generally, defense code algorithms for preventing NAND flash memory degradation can be categorized into prevention techniques and recovery techniques.

The prevention techniques are proactive measures to prevent NAND flash memories from degrading and include techniques such as garbage collection, which manages memory blocks, wear leveling, which aims to evenly distribute memory block degradation, and read reclaim, which anticipates the level of block degradation and relocates data to preemptively block failures.

Meanwhile, the recovery techniques are defined as any techniques that reduce errors or enable ECC circuits to correct errors when there are too many errors for the ECC circuits to handle.

A typical recovery defense code technique adjusts the read level of memory cells when an incorrect read level leads to an increase in errors, thus reducing the number of errors by moving the read level to its optimal position.

There are various methods for finding the read level with the least error variance. Generally, there are methods that sacrifice accuracy to quickly find the optimal read level and methods that involve more effort to find the most accurate read level possible.

Here, the methods that sacrifice accuracy to quickly find the optimal read level may be classified as a first-type defense code. In some implementations, the first-type defense code may include a performance defense code.

Examples of the first-type defense code include, for example, a predefined table (PDT) code. A defense code using a PDT continuously attempts to correct errors using a predetermined set of read levels until an ECC circuit corrects the errors. The accuracy of the read levels may not be high, but this type of method offers the advantage of allowing quick multiple attempts. Examples of the performance defense code include a Directly Aimed Recover Table (DART) code and a Read level of Program state forest Zero (RP.Z) code.

Meanwhile, in addition to this table access approach, there is an algorithm that estimates the shape near valleys in the distribution of memory cells of an NVM memory device to find an optimal valley using a mathematical algorithm. Here, algorithms for finding the optimal valley may be classified as a second-type defense code. In some implementations, the second-type defense code may include a lifetime defense code.

The second-type defense code may include, for example, a less read estimation (LRE) defense code. Since the second-type defense code requires significant resources to find the optimal valley during execution, it takes a relatively long time to complete. Other examples of the lifetime defense codes may include a Data Recovery Read (DRR) code and a Soft Decision Offset Tracking (SDOT) code.

In FIG. 11, the storage controller performs error correction on the access data re-received after the execution of the first-type defense code, to determine whether this re-received access data is error-corrected (S145).

For example, in FIG. 7, the storage controller 200 receives access data read at a read level found by the execution of the first-type defense code from the NVM device 100A and then performs error correction on this received access data to determine whether the corresponding received access data is error-corrected.

If the received access data is error-corrected (S145 - Yes), the operation of performing runtime ZQ calibration according to some embodiments is terminated (S165). Conversely, if the received access data is not error-corrected (S145 - No), the storage controller proceeds to execute the second-type defense code (S150).

For example, in FIG. 1, the processor 213 of the storage controller 200 may execute the second-type defense code by executing an algorithm corresponding to the second-type defense code, as explained earlier. The execution of the second-type defense code may involve a plurality of read operations to estimate the shape near the valleys in the distribution of the memory cells of the NVM device 100.

In FIG. 11, the storage controller performs error correction on the access data re-received after the execution of the second-type defense code, to determine whether this re-received access data is error-corrected (S155).

For example, in FIG. 7, the storage controller 200 receives access data read at a read level found by the execution of the second-type defense code from the NVM device 100A and then performs error correction on this received access data to determine whether the corresponding received access data is error-corrected.

If the received access data is error-corrected (S155 - Yes), the operation of performing runtime ZQ calibration according to some embodiments is terminated (S165). Conversely, if the received access data is not error-corrected (S155 - No), the corresponding access data is determined to be a UECC (S160).

In some implementations, for access data that is determined as being a UECC, runtime ZQ calibration, which takes relatively less time, is performed first, instead of readily executing a relatively time-consuming defense code.

That is, before performing a data sensing operation on the NVM device at a read level found by the execution of a defense code, error correction may be performed through runtime ZQ calibration on the re-received access data.

If the re-received access data is error-corrected through runtime ZQ calibration, there is no need to execute a time-consuming defense code. Accordingly, reliable data can be quickly obtained.

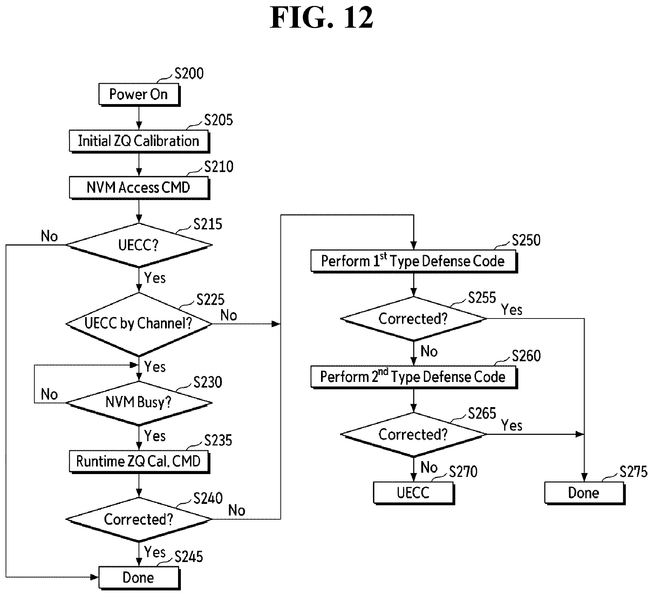

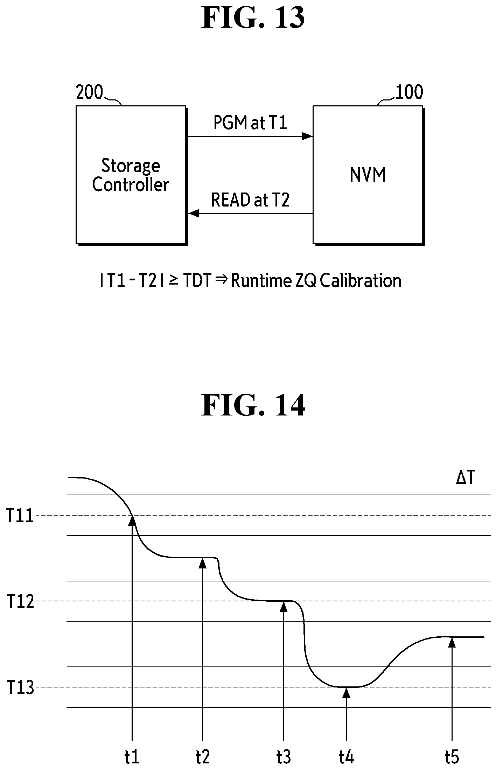

FIG. 12 is a flowchart illustrating an example of an operation of performing runtime ZQ calibration according to some implementations. FIGS. 13, 14, 15A, and 15B are diagrams explaining the operation of FIG. 12 according to some implementations.

FIG. 12 differs from FIG. 11 in that it involves determining whether a UECC originates from the channel characteristics between a storage controller and an NVM device (S225). The implementations of FIG. 12 will hereinafter be described, focusing mainly on the difference with the implementation of FIG. 11.

In FIG. 12, the storage device is powered on (S200). Thereafter, an initial ZQ calibration is performed (S205) when the storage device is powered on.

Thereafter, an access command is transmitted (S210). Thereafter, error correction is performed on the received access data to determine whether the received access data is a UECC (S215).

If the received access data has been successfully error-corrected (S215 - No), the operation of performing runtime ZQ calibration according to some implementations is terminated (S245).

If the error correction for the received access data has failed (S215 - Yes), a determination is made as to whether the corresponding UECC originates from the channel characteristics between the storage controller and the NVM device (S225).

For example, in FIG. 13, a storage controller 200 may determine whether a UECC originates from the characteristics of a channel with an NVM device 100 based on the difference between a first temperature T1 during the programming of access data corresponding to an access command into the NVM device 100 and a second temperature T2 during the reception of the access data corresponding to the access command from the NVM device 100.

For example, if the data corresponding to the access command was programmed into the NVM device 100 at the first temperature T1 and the access data corresponding to the access command was read from the NVM device 100 at the second temperature T2, the storage controller 200 may determine that the UECC originates from the channel characteristics between the storage controller 200 and the NVM device 100 if the difference between the first and second temperatures T1 and T2 exceeds a predetermined threshold temperature TDT. Then, the storage controller 200 performs run ZQ calibration in consideration that a significant change in temperature may significantly affect the SI characteristics of the channel.

According to the present disclosure, a temperature difference of 10°C can cause a significant change in the SI characteristics of the channel. Accordingly, in some implementations, the threshold temperature TDT may be set to 10°C, but the present disclosure is not limited thereto.

Thereafter, for example, in FIGS. 7 and 14, the storage controller 200 may determine whether the UECC originates from the channel characteristics by determining whether the temperature during the reception of the access data corresponding to the access command from the NVM device 100A falls within a predetermined range.

For example, the storage controller 200 may first set several reference ranges, i.e., T11 ± ΔT, T12 ± ΔT, and T13 ± ΔT. Here, temperatures T11, T12, and T13 may be where checking and reflecting the channel characteristics is required.

If the temperature during the reception of the access data corresponding to the access command from the NVM device 100A falls within the reference range of T11 ± ΔT, T12 ± ΔT, or T13 ± ΔT, the storage controller 200 may determine that the UECC originates from the channel characteristics.

That is, for times t1, t3, and t4 when the temperature during the reception of the access data corresponding to the access command from the NVM device 100A falls within the reference range of T11 ± ΔT, T12 ± ΔT, or T13 ± ΔT, the storage controller 200 may determine that the UECC originates from the channel characteristics, and may then perform runtime ZQ calibration. Conversely, for other times t2 and t5, the storage controller 200 may determine that the UECC is not based on the channel characteristics, and may execute a defense code that will be described later. For example, the storage controller 200 may determine at the time t2 that the channel characteristics at the time t1 have been maintained, and may determine at the time t5 that the channel characteristics at the time t5 have been maintained.

Additionally, in some implementations, the storage controller 200 may determine whether the UECC originates from the channel characteristics if a predetermined difference is detected based on Self-Monitoring Analysis and Reporting Technology (SMART) temperature information.

SMART, which is a monitoring system where the NVM device 100A performs self-diagnosis and analysis to provide information to the storage controller 200, assesses the reliability of the storage device and diagnoses and reports potential failure risks. When SMART predicts a failure, the user can prevent unexpected overvoltage issues or data loss by replacing the drive. Storage device manufacturers can use SMART data to identify any problems and reference them in future drive designs to prevent failures.

For example, if the temperature at the time when the storage device is powered on (S200 in FIG. 12) or when an initial ZQ calibration is performed (S205 in FIG. 12) exceeds a predetermined range compared to the temperature of the SMART information received from the NVM device 100A, the storage controller 200 may determine that the UECC originates from the channel characteristics. The researchers of the present disclosure have experimentally confirmed that a temperature difference of 10°C can significantly alter the SI characteristics of channels, but the present disclosure is not limited thereto.

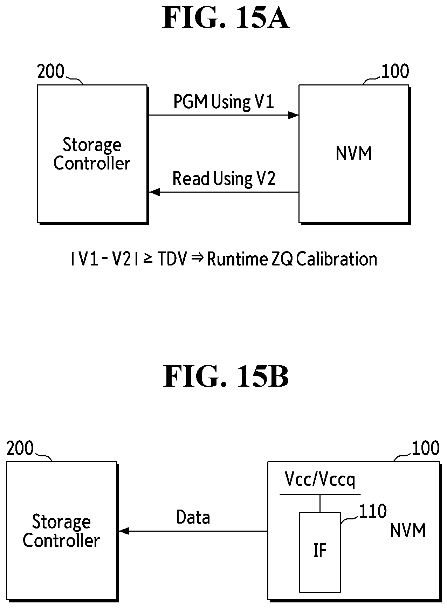

Thereafter, in FIG. 15A, for example, the storage controller 200 may determine whether the UECC originates from the channel characteristics by determining the difference between a first voltage V1 used when programming the access data corresponding to the access command into the NVM device 100, and a second voltage V2 used when receiving the access data corresponding to the access command from the NVM device 100. Here, the first and second voltages V1 and V2 may be the voltages (e.g., a power supply voltage) used to transmit and receive data through the channel.

For example, if the access data corresponding to the access command is programmed into the NVM device 100 using the first voltage V1 and is read from the NVM device 100 using the second voltage V2, and the difference between the first and second voltages V1 and V2 exceeds a predetermined threshold voltage TDV, the storage controller 200 may determine that the UECC originates from the channel characteristics between the storage controller 200 and the NVM device 100, and may perform runtime ZQ calibration in consideration that significant changes in the voltages used to transmit and receive data suggest significant changes in the SI characteristics of the channel.

In the present disclosure, a voltage difference of 0.2V can significantly alter the SI characteristics of channels. Accordingly, in some implementations, the threshold voltage TDV may be set to 0.2V, but the present disclosure is not limited thereto.

In FIG. 15B, for example, the storage controller 200 may determine whether the UECC originates from the channel characteristics by checking voltage fluctuations during the reception of the access data corresponding to the access command from the NVM device 100.

An input/output interface 110 of the NVM device 100 may transmit the access data corresponding to the access command to the storage controller 200 using, for example, a power supply voltage Vcc or Vccq. Here, the voltage Vccq may be, for example, the voltage used to transmit data through a DQ port.

If a fluctuation in the voltage Vcc or Vccq used to transmit and receive data during the reception of the access data corresponding to the access command from the NVM device 100 exceeds, for example, 10% of the corresponding voltage, the storage controller 200 may determine that the UECC originates from the channel characteristics.

For example, if the voltage Vcc or Vccq is 2.5V, the storage controller 200 may determine that the UECC originates from the channel characteristics, and may perform runtime ZQ calibration may be performed when a voltage fluctuation of 0.25V or greater is detected.

Additionally, in some implementations, if a voltage fluctuation of 0.2V or greater is detected, the storage controller 200 may determine that the UECC originates from the channel characteristics, and may perform runtime ZQ calibration.

In some implementations, the storage controller 200 may detect such voltage fluctuation using a built-in low voltage detector (LVD). Additionally, in some implementations, the storage controller 200 may detect such voltage fluctuation using a power management IC (PMIC).

In FIG. 12, if the UECC is determined as originating from the channel characteristics between the storage controller and the NVM device (S225 - Yes), the storage controller determines whether the NVM device is in a busy state (S230).

If the NVM devices are not in the busy state (S230 - No), the storage controller waits until the NVM device enters the busy state.

If the NVM device is in the busy state (S230 - Yes), the storage controller sends a runtime ZQ calibration command (S235).

Then, the storage controller performs error correction on re-received access data to determine whether the re-received access data is error-corrected (S240).

If the re-received access data is error-corrected (S240 - Yes), the operation of performing runtime ZQ calibration according to some implementations is terminated (S245). Conversely, if the received access data is not error-corrected (S240 - No), a first-type defense code is executed (S250).

Additionally, if the UECC is determined as not originating from the channel characteristics between the storage controller and the NVM device (S225 - No), the first-type defense code is executed (S250).

Thereafter, the storage controller performs error correction on the access data re-received after the execution of the first-type defense code, to determine whether this re-received access data is error-corrected (S255).

If the re-received access data is error-corrected (S255 - Yes), the operation of performing runtime ZQ calibration according to some embodiments is terminated (S275). Conversely, if the re-received access data is not error-corrected (S255 - No), a second-type defense code is executed (S260).

Thereafter, the storage controller performs error correction on the access data re-received after the execution of the second-type defense code, to determine whether this re-received access data is error-corrected (S265).

If the re-received access data is error-corrected (S265 - Yes), the operation of performing runtime ZQ calibration according to some implementations is terminated (S275). Conversely, if the re-received access data is not error-corrected (S265 - No), the corresponding access data is determined to be a UECC (S270).

In some implementations, error correction may be effectively performed through the operation of determining whether a UECC originates from the characteristics of the channel between a storage controller and an NVM device.

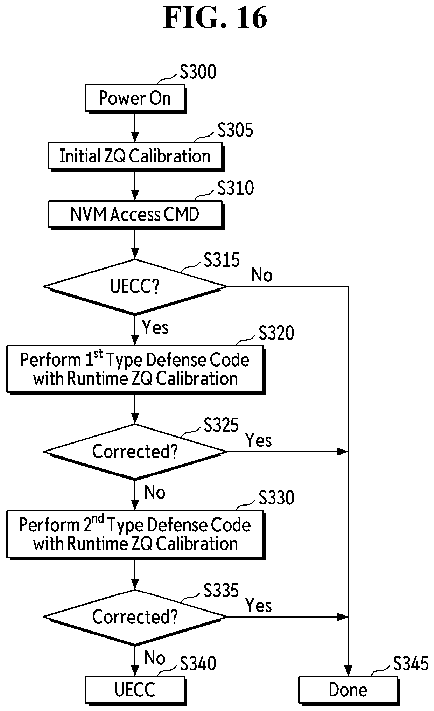

FIG. 16 is a flowchart illustrating an example of an operation of performing runtime ZQ calibration according to some implementations. In FIG. 16, a storage device is powered on (S300). Then, when the storage device is powered on, an initial ZQ calibration is performed (S305).

Thereafter, an access command is transmitted (S310). Thereafter, error correction is performed on received access data, and a determination is made as to whether the received access data is a UECC (S315).

If the error correction for the received access data has succeeded (S315 - No), the operation of performing runtime ZQ calibration according to some implementations is terminated (S345).

If the error correction for the received access data has failed (S315 - Yes), a first-type defense code is executed (S320) while runtime ZQ calibration is being performed.

For example, the storage controller may execute the first-type defense code, which searches for a read level to read the data corresponding to the access command. During the execution of the first-type defense code, the storage controller determines whether an NVM device is in a busy state, and in response to the NVM device being determined as being in the busy state, the storage controller may send a runtime ZQ calibration command to the NVM device.

As explained earlier, executing the first-type defense code requires reading the data stored in the NVM device at a new read level, leading to a period when the NVM device is in the busy state. In some implementations, during such period, a runtime ZQ calibration command is sent to the NVM device to perform runtime ZQ calibration that reflects the channel characteristics between the storage controller and the NVM device.

Additionally, in some implementations, the storage controller may execute one code corresponding to the first-type defense code and may determine whether the NVM device is in the busy state, before executing another code corresponding to the first-type defense code, and in response to the NVM device being determined as being in the busy state, the storage controller may send a runtime ZQ calibration command to the NVM device.

As previously mentioned, examples of the first-type defense code include, for example, a PDT defense code, a DART defense code, and a RP.Z defense code.

For example, the storage controller may determine whether the NVM device is in the busy state between the execution of the PDT defense code and the execution of the DART defense code, and in response to the NVM device being determined as being in the busy state, the storage controller may send a runtime ZQ calibration command to the NVM device.

In FIG. 16, error correction is performed on the access data re-received after the execution of the first-type defense code, to determine whether this re-received access data is corrected (S325).

If the re-received access data is error-corrected (S325 - Yes), the operation of performing runtime ZQ calibration according to some implementations is terminated (S345). Conversely, if the re-received access data is not error-corrected (S325 - No), the second-type defense code is executed (S330).

For example, the storage controller may execute the second-type defense code, which more precisely searches for a read level to read the data corresponding to the access command. During the execution of the second-type defense code, the storage controller determines whether the NVM device is in the busy state, and in response to the NVM device being determined as being in the busy state, the storage controller may send a runtime ZQ calibration command to the NVM device.

As explained earlier, executing the second-type defense code requires reading the data stored in the NVM device to find a new read level and then reading the data at the new read level, resulting in a period where the NVM device is in the busy state. In some implementations, during such period, a runtime ZQ calibration command is sent to the NVM device to perform runtime ZQ calibration that reflects the channel characteristics between the storage controller and the NVM device.

Additionally, in some implementations, the storage controller may execute one code corresponding to the second-type defense code and may determine whether the NVM device is in the busy state, before executing another code corresponding to the second-type defense code, and in response to the NVM device being determined as being in the busy state, the storage controller may send a runtime ZQ calibration command to the NVM device.

As previously explained, examples of the second-type defense code include, for example, an LRE defense code, a DRR defense code, and an SDOT defense code.

For example, the storage controller may execute the LRE defense code and may determine whether the NVM device is in the busy state, before executing the SDOT defense code, and in response to the NVM device being determined as being in the busy state, the storage controller may send a runtime ZQ calibration command to the NVM device.

In FIG. 16, error correction is performed on the access data re-received after the execution of the second-type defense code, to determine whether this re-received access data is error-corrected (S335).

If the re-received access data is error-corrected (S335 - Yes), the operation of performing runtime ZQ calibration according to some implementations is terminated (S345). Conversely, if the re-received access data is not error-corrected (S335 - No), the corresponding access data is determined to be a UECC (S340).

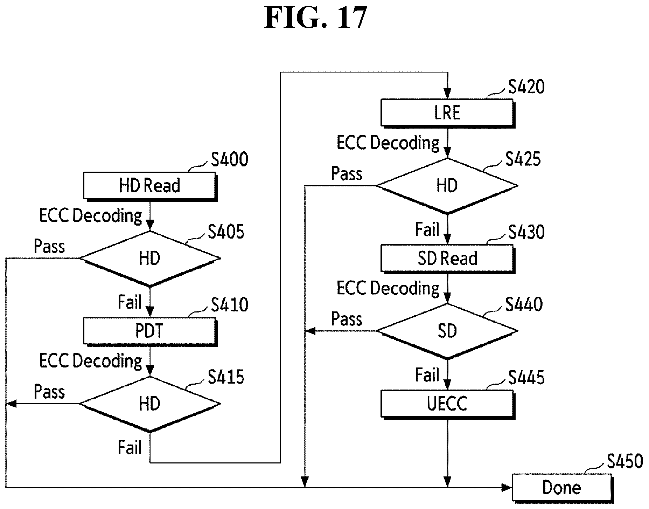

FIG. 17 is a flowchart illustrating an example of an error correction operation through the execution of a defense code according to some implementations. In FIG. 17, a storage device may perform error correction through a combination of an ECC operation and a read level search algorithm using a defense code.

First, a hard decision (HD) read is performed (S400), and HD decoding is performed (S405).

HD read is a read method that reads near valleys only once to extract ones or zeros. On the other hand, soft decision (SD) read is a read method that reads the near valleys multiple times using different read levels and additionally extracts information on how reliable the extracted zeros or ones are.

HD decoding refers to ECC decoding (or correction) using only the result of an HD read, and SD decoding refers to ECC decoding using both the result of an HD read and the result of an SD read. The error correction capability of SD decoding is much more favorable than the error correction capability of HD decoding. However, an SD read involves more reads than an HD read, affecting the product's operational latency. Accordingly, it is efficient to perform an HD read and HD decoding first and then to perform an SD read and SD decoding if the HD decoding fails.

If error correction is successful through the HD decoding performed in S405 (S405 - Pass), the error correction operation according to some implementations is terminated (S450). Conversely, if error correction fails through the HD decoding performed in S405 (S405 - Fail), a first-type defense code, such as a PDT defense code, is executed to search for a new read level (S410). The PDT defense code is a technique that stores recoverable read level values in advance through profiling for various situations where errors may occur, and then attempts to quickly recover errors using the stored values upon the occurrence of the errors.

Thereafter, HD decoding is performed again (S415). If error correction is successful through the HD decoding performed in S415 (S415 - Pass), the error correction operation is terminated (S450). Conversely, if error correction fails through the HD decoding performed in S415 (S415 - Fail), a precise valley search algorithm is performed by executing a second-type defense code, such as an LRE defense code (S420). The LRE defense code is a technique that finds an optimal read level using cell count information to model the distribution of memory cells as a quadratic or cubic equation.

Thereafter, HD decoding is performed again (S425). If error correction is successful through the HD decoding performed in S425 (S425 - Pass), the error correction operation is terminated (S450). Conversely, if error correction fails through the HD decoding performed in S425 (S425 - Fail), an SD read is performed (S430), and then, SD decoding is performed (S440).

If error correction is successful through the SD decoding (S440 - Pass), the error correction operation is terminated (S450). Conversely, if error correction fails through the SD decoding (S440 - Fail), the corresponding data is determined to be a UECC (S445).

During the error correction operation of FIG. 17, there are periods when an NVM device is in a busy state to read data therefrom. In some implementations, the storage device can perform runtime ZQ calibration during such period when the NVM device is in the busy state.

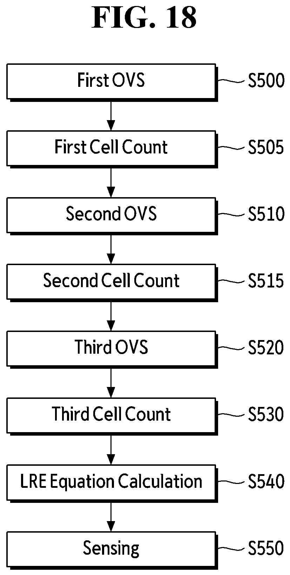

FIG. 18 is a flowchart illustrating an example of an operation of executing the LRE defense code as performed in the error correction operation of FIG. 17 according to some implementations. In FIG. 18, a first on-chip valley search (OVS) operation is performed at a first develop time (S500), and first cell counting is performed accordingly (S505).

Thereafter, a second OVS operation is performed at a second develop time (S510), and second cell counting is performed accordingly (S515).

Thereafter, a third OVS operation is performed at a third develop time (S520), and third cell counting is performed accordingly (S530).

Thereafter, an equation for modeling the distribution of memory cells is calculated using cell count information (S540). Thereafter, sensing is performed using a discovered read level (S550).

In some implementations, for example, while a storage controller is calculating the equation for modeling the cell distribution using the cell count information (S540), a runtime ZQ calibration command is sent to an NVM device so that runtime ZQ calibration reflecting the channel characteristics between the storage controller and the NVM device can be performed.

While this disclosure contains many specific implementation details, these should not be construed as limitations on the scope of what may be claimed, equivalents thereof, as well as claims to be described later. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Embodiments are set out in the following clauses:
Clause 1. A storage device comprising:
   a non-volatile memory (NVM) device configured to store data; and
   a storage controller configured to control the NVM device,
   wherein the storage controller is further configured to:
      send an access command to the NVM device to access data stored in the NVM device;
      receive first access data corresponding to the access command from the NVM device;
      perform error correction on the first access data;
      determine that the first access data is an uncorrectable error correction code (UECC);
      based on the first access data being determined as being the UECC, determine that the UECC originates from channel characteristics between the storage controller and the NVM device;
      based on the UECC being determined as originating from the channel characteristics, send a runtime ZQ calibration command to the NVM device; and
      based on the UECC being determined as not originating from the channel characteristics, execute a defense code configured to search for a read level to read data corresponding to the access command.
Clause 2. The storage device of clause 1, wherein the storage controller is configured to:
   based on the UECC being determined as originating from the channel characteristics, determine that the NVM device is in a busy state; and
   based on the NVM device being determined as being in the busy state, send a runtime ZQ calibration command to the NVM device.
Clause 3. The storage device of clause 2, wherein the storage controller is configured to:
   determine that the NVM device is in the busy state based on a ready/busy (R/B) signal output from the NVM device; and
   send a runtime ZQ calibration command to the NVM device using a DQ port through which the first access data has been received from the NVM device.
Clause 4. The storage device of any of clauses 1 to 3, wherein the storage controller is configured to determine that the UECC originates from the channel characteristics based on a difference between a first temperature during the programming of the data corresponding to the access command into the NVM device and a second temperature during the reception of the first access data corresponding to the access command from the NVM device.
Clause 5. The storage device of any of clauses 1 to 4, wherein the storage controller is configured to determine that the UECC originates from the channel characteristics based on a voltage fluctuation during the reception of the first access data corresponding to the access command from the NVM device.
Clause 6. An operating method of a storage controller, comprising:
   sending, using at least one computing device, an access command to a non-volatile memory (NVM) device to access data stored in the NVM device (S110);
   receiving, using the at least one computing device, first access data corresponding to the access command from the NVM device;
   performing, using the at least one computing device, error correction on the first access data (S115);
   based on the first access data being determined as being an uncorrectable error correction code (UECC) (S115-yes), determining, using the at least one computing device, whether the NVM device is in a busy state (S120); and
   based on the NVM device being determined as being in the busy state (S120-yes), sending, using the at least one computing device, a runtime ZQ calibration command to the NVM device (S125).
Clause 7. The operating method of clause 6, further comprising:
   receiving second access data corresponding to the access command from the NVM device through a channel between the storage controller and the NVM device, where runtime ZQ calibration has been performed according to the runtime ZQ calibration command;
   performing error correction on the second access data; and
   based on the second access data being determined as being the UECC, executing a defense code configured to search for a read level to read data corresponding to the access command.
Clause 8. The operating method of clause 6 or clause 7, wherein the determining that the NVM device is in the busy state, comprises:
   determining that the UECC originates from the channel characteristics between the storage controller and the NVM device;
   based on the UECC being determined as originating from the channel characteristics, determining that the NVM device is in a busy state; and
   based on the UECC being determined as not originating from the channel characteristics, executing a defense code configured to search for a read level to read data corresponding to the access command.
Clause 9. The operating method of clause 8, wherein the determining that the UECC originates from the channel characteristics, further comprises determining that the UECC originates from a difference between a first temperature during the programming of the data corresponding to the access command into the NVM device and a second temperature during the reception of the first access data corresponding to the access command from the NVM device.
Clause 10. The operating method of clause 8 or clause 9, wherein the determining that the UECC originates from the channel characteristics, further comprises determining that a temperature during the reception of the first access data corresponding to the access command from the NVM device falls within a predetermined range.
Clause 11. The operating method of any of clauses 8 to 10, wherein the determining that the UECC originates from the channel characteristics, further comprises determining that the UECC originates from the channel characteristics based on a difference between a first voltage used to program the data corresponding to the access command into the NVM device and a second voltage used to read the first access data corresponding to the access command from the NVM device.
Clause 12. The operating method of any of clauses 8 to 11, wherein the determining that the UECC originates from the channel characteristics, further comprises determining that the UECC originates from the channel characteristics based on a voltage fluctuation during the reception of the first access data corresponding to the access command from the NVM device.
Clause 13. The operating method of any of clauses 6 to 12, wherein the determining that the NVM device is in the busy state, comprises:
   executing a defense code configured to search for a read level to read data corresponding to the access command; and
   determining that the NVM device is in the busy state during the execution of the defense code.
Clause 14. The operating method of any of clauses 6 to 13, wherein the determining that the NVM device is in the busy state, comprises determining that the NVM device is in the busy state based on a ready/busy (R/B) signal output from the NVM device.
Clause 15. The operating method of any of clauses 6 to 14, wherein the sending the runtime ZQ calibration command to the NVM device, comprises sending the runtime ZQ calibration command to the NVM device using a DQ port through which the first access data is received from the NVM device.

## Claims

1. A storage device (1) comprising:
a non-volatile memory (NVM) device (100) configured to store data; and
a storage controller (200) configured to control the NVM device,
wherein the storage controller is configured to:
send an access command to the NVM device to access data stored in the NVM device (S110);
receive first access data corresponding to the access command from the NVM device;
perform error correction on the first access data;
determine that the first access data is an uncorrectable error correction code (UECC) (S115);
based on the first access data determined as being the UECC (S115-yes), determine that the NVM device is in a busy state (S120); and
based on the NVM device being determined as being in the busy state (S120-yes), send a runtime ZQ calibration command to the NVM device (S125).

2. The storage device of claim 1, wherein the NVM device is configured to perform runtime ZQ calibration according to the runtime ZQ calibration command, and
wherein the storage controller is configured to:
receive second access data corresponding to the access command from the NVM device through a channel between the storage controller and the NVM device;
perform error correction on the second access data; and
based on the second access data being determined as being the UECC, execute a defense code for searching for a read level to read data corresponding to the access command.

3. The storage device of claim 2, wherein the defense code includes a first-type defense code configured to search for the read level using a table, and a second-type defense code configured to search for the read level through a read operation of the data stored in the NVM device.

4. The storage device of any preceding claim, wherein the storage controller is configured to:
based on the first access data being determined as being the UECC, determine that the UECC originates from channel characteristics between the storage controller and the NVM device;
based on the UECC being determined as originating from the channel characteristics between the storage controller and the NVM device, send the runtime ZQ calibration command to the NVM device; and
based on the UECC being determined as not originating from the channel characteristics, execute a defense code configured to search for a read level to read data corresponding to the access command.

5. The storage device of claim 4, wherein the storage controller is configured to determine that the UECC originates from the channel characteristics based on a difference between (i) a first temperature during the programming of the data corresponding to the access command into the NVM device and (ii) a second temperature during the reception of the first access data corresponding to the access command from the NVM device.

6. The storage device of claim 4 or claim 5, wherein the storage controller is configured to determine that the UECC originates from the channel characteristics by determining that a temperature during the reception of the first access data corresponding to the access command from the NVM device falls within a predetermined range.

7. The storage device of any of claims 4-6, wherein the storage controller is configured to determine that the UECC originates from the channel characteristics based on whether a difference between (i) a temperature when the storage device is powered on or an initial ZQ calibration is performed and (ii) a temperature during the reception of the first access data corresponding to the access command from the NVM device exceeds a first value.

8. The storage device of any of claims 4-7, wherein the storage controller is configured to determine that the UECC originates from the channel characteristics based on a difference between (i) a first voltage used to program the data corresponding to the access command into the NVM device and (ii) a second voltage used to read the first access data corresponding to the access command from the NVM device.

9. The storage device of any of claims 4-8, wherein the storage controller is configured to determine that the UECC originates from the channel characteristics based on a voltage fluctuation during the reception of the first access data corresponding to the access command from the NVM device.

10. The storage device of claim 9, wherein the storage controller is configured to determine that the UECC originates from the channel characteristics by determining that a fluctuation in a voltage supplied to an input/output interface of the NVM device for transmitting the first access data corresponding to the access command exceeds a first ratio.

11. The storage device of any preceding claim, wherein the storage controller is configured to:
based on the first access data being determined as being the UECC, execute a defense code for searching for a read level to read data corresponding to the access command;
determine that the NVM device is in a busy state during the execution of the defense code; and
based on the NVM device being determined as being in the busy state, send a runtime ZQ calibration command to the NVM device.

12. The storage device of claim 11,
wherein the defense code includes a less read estimation (LRE) defense code, and
wherein the storage controller is configured to send the runtime ZQ calibration command to the NVM device while calculating an equation for modeling a distribution of memory cells based on cell count information during the execution of the LRE defense code.

13. The storage device of any preceding claim, wherein the storage controller is configured to:
based on the first access data being determined as being the UECC, execute a first defense code for searching for a read level to read data corresponding to the access command;
determine that the NVM device is in a busy state during the execution of the first defense code and before executing a second defense code; and
based on the NVM device being determined as being in the busy state, send a runtime ZQ calibration command to the NVM device.

14. The storage device of any preceding claim, wherein the storage controller is configured to:
determine that the NVM device is in a busy state based on a ready/busy (R/B) signal output from the NVM device; and
send a runtime ZQ calibration command to the NVM device using a DQ port through which the first access data has been received from the NVM device.

15. An operating method of a storage controller, comprising:
sending, using at least one computing device, an access command to a non-volatile memory (NVM) device to access data stored in the NVM device (S110);
receiving, using the at least one computing device, first access data corresponding to the access command from the NVM device;
performing, using the at least one computing device, error correction on the first access data (S115);
based on the first access data being determined as being an uncorrectable error correction code (UECC) (S115-yes), determining, using the at least one computing device, whether the NVM device is in a busy state (S120); and
based on the NVM device being determined as being in the busy state (S120-yes), sending, using the at least one computing device, a runtime ZQ calibration command to the NVM device (S125).
